# EUROPEAN PATENT APPLICATION

(11) **EP 4 682 940 A1**
(43) Date of publication of application: **21.01.2026**
(21) Application number: 24770273.1
(22) Date of filing: 05.02.2024
(51) Int. Cl.: H01L 21/3065, H01L 21/302

(54) **ETCHING METHOD AND ETCHING DEVICE**

(30) Priority: 13.03.2023 JP 2023038892
(71) Applicant: Tokyo Electron Limited, Tokyo 107-6325 (JP)
(72) Inventor: JEUNG, Woonghyun, Yamanashi 4070192 (JP); ASADA, Yasuo, Yamanashi 4070192 (JP); ASAHI, Kenshiro, Hsin-chu City 30078 (TW)
(74) Representative: Diehl & Partner
(86) International application number: PCT/JP2024/003640
(87) International publication number: WO 2024/190153

(57) **Abstract**

An etching method according to the present disclosure includes an etching step in which a halogen-containing gas, an ammonia gas, and an amine gas are supplied as etching gases to a substrate including a silicon oxide film formed on a surface of the substrate, and the silicon oxide film is etched.

## Description

### TECHNICAL FIELD

The present disclosure relates to an etching method and an etching apparatus.

### BACKGROUND

In a manufacturing process of a semiconductor device, etching is performed on a silicon oxide film formed on a substrate such as a semiconductor wafer (hereinafter referred to as "wafer"). Patent Document 1 discloses that etching is performed by supplying an amine gas to the silicon oxide film.

### [Prior Art Documents]

### [Patent Documents]

Patent Document 1: International Patent Pamphlet No. WO2020/054476A1

### SUMMARY

The present disclosure provides a technique capable of achieving a desired shape of an etched silicon oxide film when etching the silicon oxide film formed on a substrate.

An etching method of the present disclosure includes: etching a silicon oxide film by supplying a halogen-containing gas, an ammonia gas, and an amine gas as etching gases to a substrate including the silicon oxide film formed on a surface of the substrate.

According to the present disclosure, it is possible to achieve a desired shape of an etched silicon oxide film when etching the silicon oxide film formed on a substrate.

### BRIEF DESCRIPTION OF DRAWINGS

FIG. 1 is a vertical cross-sectional view of a wafer as a workpiece on which an etching method according to one embodiment of the present disclosure is performed.
FIGS. 2A to 2D are vertical cross-sectional views of a wafer illustrating an etching step in a comparative example.
FIGS. 3A and 3B are vertical cross-sectional views of the wafer illustrating the etching step in the comparative example.
FIGS. 4A to 4D are vertical cross-sectional views of a wafer illustrating an etching step in another comparative example.
FIG. 5 is an explanatory diagram illustrating the outline of the present embodiment.
FIGS. 6A to 6D are vertical cross-sectional views illustrating an etching step of the present embodiment.
FIG. 7 is a chart illustrating the etching step of the present embodiment.
FIG. 8 is a vertical cross-sectional view illustrating an apparatus for performing the etching step of the present embodiment.
FIG. 9 is a graph illustrating results of an evaluation test.
FIG. 10 is an explanatory diagram illustrating images of evaluation test results.
FIG. 11 is an explanatory diagram illustrating images of evaluation test results.
FIG. 12 is an explanatory diagram illustrating images of evaluation test results.

### DETAILED DESCRIPTION

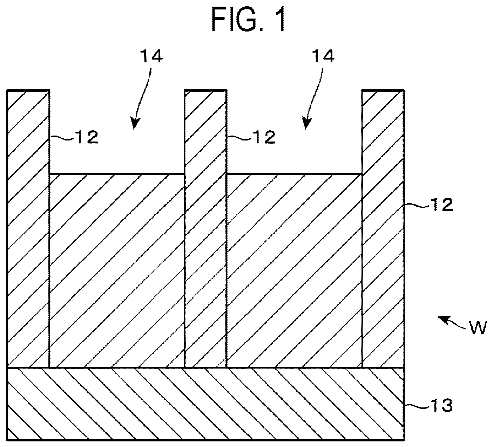

An embodiment (Example) of an etching method of the present disclosure is described. To outline the etching method, a halogen-containing gas, an ammonia (NH₃) gas, and an amine gas are supplied as etching gases to a substrate, namely, a wafer W, thereby etching a silicon oxide (SiOx) film 11 on a surface of the wafer W. As illustrated in FIG. 1, a Si film 12 is formed on the surface of the wafer W, and a groove is formed in the Si film 12. Thus, a recess 14 that opens in a thickness direction of the wafer W is formed by the Si film 12 and an underlying film 13 formed below the Si film 12, and the Si film 12 is configured as a sidewall forming the recess 14. In addition, the underlying film 13 is omitted in some of the drawings described later.

Further, the SiOx film 11 is formed in the recess 14. Using the aforementioned etching gases, among silicon-containing films exposed on the surface of the wafer W, namely, the SiOx film 11 and the Si film 12, the SiOx film 11 is selectively etched. The etching is performed such that a portion of the SiOx film 11 remains in the recess 14 after the etching. In addition, no plasma is created around the wafer W in performing this etching.

In a more detailed description of the etching in Example, a desired amount of the SiOx film 11 is etched by repeating the supply of the etching gases to the wafer W and sublimation (including vaporization) of reaction products while stopping the supply of the etching gases to the wafer W. In addition, in Example, a hydrogen fluoride (HF) gas may be used as a halogen-containing gas, which is one of the etching gases.

As described above, the etching gases include an NH₃ gas and an amine gas, each being a basic gas. The use of both the NH₃ gas and the amine gas enables a top surface (surface) of the SiOx film 11 remaining in the recess 14 after the etching to have relatively high flatness, thereby preventing degradation in performance of a semiconductor device manufactured from the wafer W due to poor flatness. In addition, in Example, a HF gas may be used as the halogen-containing gas, and a trimethylamine (TMA) gas is used as the amine gas.

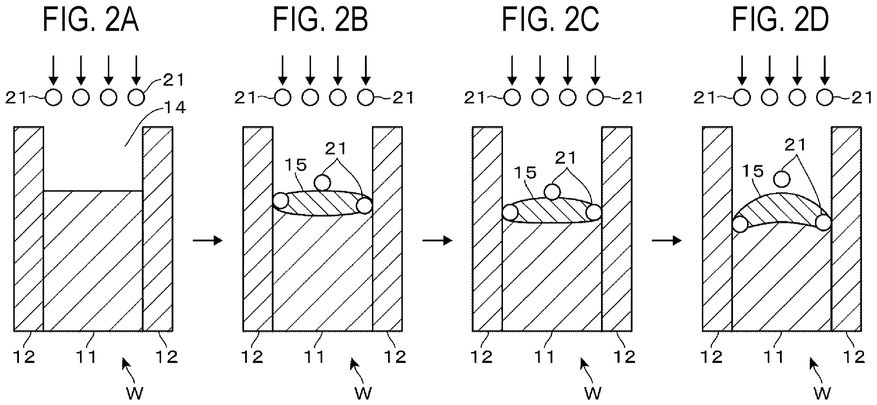

To clearly show effects of the etching gases in Example, processing in Comparative Examples is first described below. Processing using a HF gas and NH₃ gas as etching gases is referred to as Comparative Example 1, and processing using a HF gas and TMA gas as etching gases is referred to as Comparative Example 2. First, etching in Comparative Example 1 is described. FIGS. 2A to 3B are vertical cross-sectional views of the wafer W illustrating changes in the SiOx film 11 that are estimated to occur during the processing of Comparative Example 1. In the drawings, the etching gases including the HF gas and NH₃ gas are illustrated as an etching gas 21. In addition, unless otherwise specified in the following description, references to left and right ends and a lateral central portion in relation to the SiOx film 11 refer to left and right ends and a lateral central portion in a vertical cross-sectional view.

When the etching gas 21 is supplied to the wafer W adjusted to a predetermined temperature (FIG. 2A), a surface of the SiOx film 11 in the recess 14 reacts with the etching gas 21 to form a layer 15 containing ammonium fluorosilicate [(NH₄)SiF₆: AFS] as reaction products. An unevenness in a thickness of the AFS layer 15 occurs between the left and right ends and the central portion on the SiOx film 11 (FIG. 2B).

More specifically, the etching gas 21 is supplied more to the lateral central portion of the SiOx film 11 (i.e., a region relatively distant from an interface with the Si film 12) than to the left and right ends (i.e., a region near the interface with the Si film 12). Therefore, the AFS layer 15 becomes thicker at the lateral central portion than at the left and right ends. In addition, the reason for this variation in a supply amount of the etching gas 21 across various regions of the SiOx film is due to the Si film 12, which is described in detail in Comparative Example 2.

The lateral central portion of the SiOx film 11 tends to less come into contact with the etching gas 21 due to the formation of the relatively thick AFS layer 15 at the lateral central portion of the SiOx film 11. In contrast, the left and right ends of the SiOx film 11 more easily come into contact with the etching gas 21 since the thickness of the AFS layer 15 formed at the left and right ends of the SiOx film 11 is relatively thin. Therefore, the reaction progresses more at the left and right ends than at the lateral central portion of the SiOx film 11, leveling surface heights of the SiOx film 11 between the lateral central portion and the left and right ends (FIG. 2C). However, as illustrated in evaluation tests described below, AFS has low adsorbability to Si but high adsorbability to itself, leading to aggregation. Among AFS forming the AFS layer 15, AFS near the interface with the Si film 12 desorbs from the AFS layer 15. That is, if the supply of the etching gas 21 continues, the thickness of the AFS layer 15 on the left and right ends of the SiOx film 11 decreases (FIG. 2D).

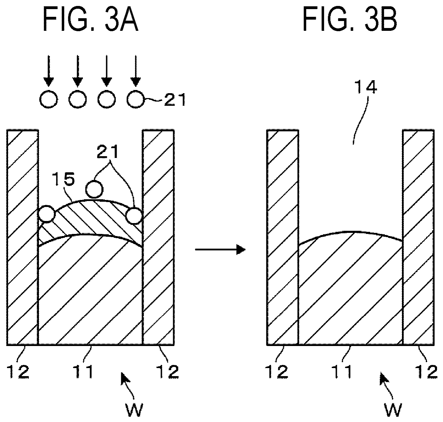

As the thickness of the AFS layer 15 decreases in this manner, the reaction with the etching gas 21 progresses more readily at the left and right ends of the SiOx film 11, but is relatively prevented at the lateral central portion. Then, the AFS layer 15 becomes thick again over both the left and right ends and the lateral central portion of the SiOx film 11, which hinders contact with the etching gas 21 and stops the reaction (FIG. 3A). At the time of the stopping of the reaction, the surface of the SiOx film 11 has a convex shape with the lateral central portion higher than the left and right ends since the reaction progressed as described so far. Then, although the AFS layer 15 is removed by adjusting a temperature of the wafer W and exhausting an atmosphere around the wafer W after stopping the supply of the etching gas 21 to the wafer W, the SiOx film 11 retains the convex shape (FIG. 3B). Accordingly, the surface flatness of the SiOx film 11 is relatively low.

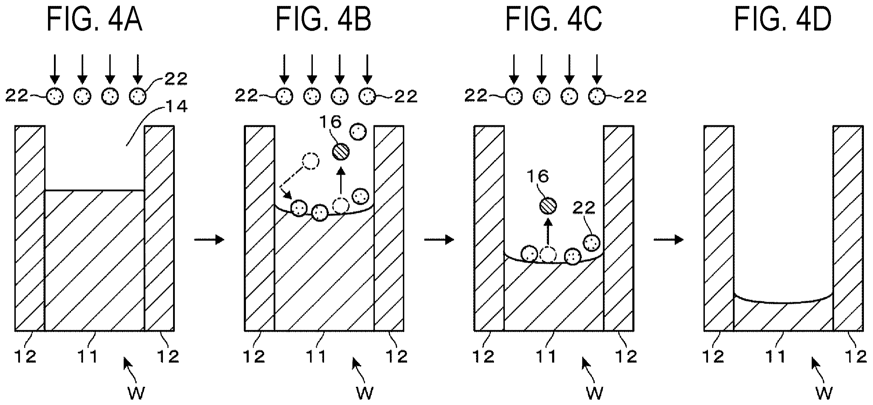

Next, etching in Comparative Example 2 is described with reference to FIGS. 4A to 4D with a focus on differences from Comparative Example 1. FIGS. 4A to 4D are vertical cross-sectional views of the wafer W illustrating changes in the SiOx film 11 that are estimated to occur during the processing of Comparative Example 2. FIGS. 4A to 4D are vertical cross-sectional views illustrating changes in the wafer W that are estimated to occur during this etching. In FIGS. 4A to 4D, the etching gases including a HF gas and TMA gas are illustrated as an etching gas 22. When the etching gas 22 is supplied to the wafer W adjusted to a predetermined temperature (FIG. 4A), the surface of the SiOx film 11 in the recess 14 reacts with the etching gas 22, and a reaction product 16 is generated. The reaction product 16 has a lower sublimation temperature compared to the AFS generated from the NH₃ gas. Accordingly, the reaction product 16 sublimates quickly after its generation, and contact between the etching gas 22 and the SiOx film 11 is unlikely to be hindered by the reaction product 16 (FIG. 4B).

In addition, a portion of the etching gas 22 is supplied downward along an opening direction of the recess 14, while another portion is supplied obliquely with respect to the opening direction. The portion of the etching gas 22 supplied in this manner bounces off the Si film 12 while moving downward, thereby being supplied to the lateral central portion of the SiOx film 11 in the vertical cross-sectional view. That is, molecules of the etching gas 22 are directly supplied to the lateral central portion, or molecules that have bounced off the Si film 12 are supplied to the lateral central portion. In other words, a relatively large number of molecules of the etching gas 22 collide with the lateral central portion of the SiOx film 11, but due to the above-described bouncing, molecules are less likely to collide with the left and right ends. Consequently, etching of the SiOx film 11 progresses more significantly in the central portion than in the left and right ends due to a difference in collision probabilities of the molecules (FIG. 4C). Therefore, the surface of the SiOx film 11 after completion of the etching has a concave shape with the lateral central portion lower than the left and right ends in the vertical cross-sectional view (FIG. 4D). Accordingly, the surface flatness of the SiOx film 11 is relatively low.

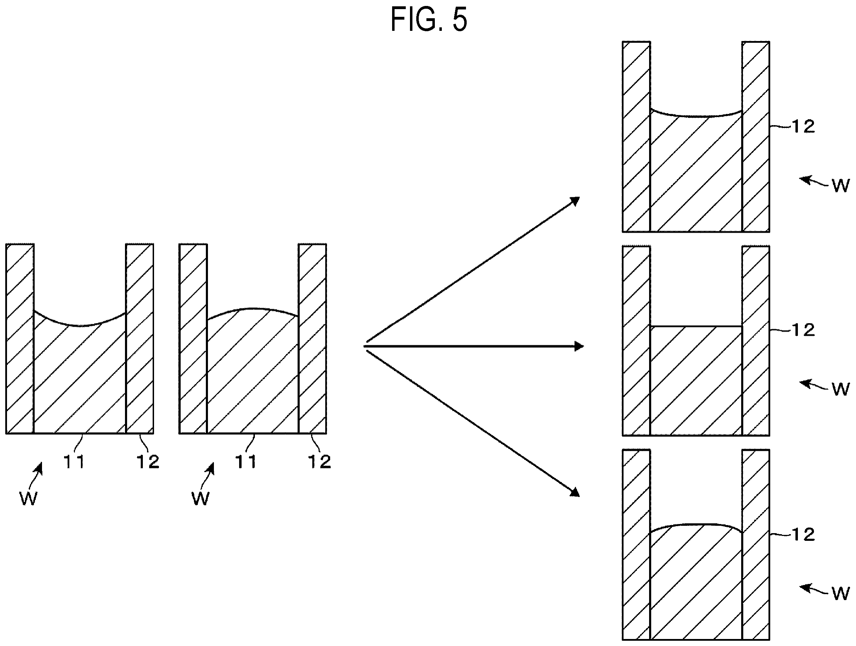

FIG. 5 is a conceptual diagram illustrating etching in Example. The left side of the drawing illustrates the SiOx film 11 etched using one of an NH₃ gas and a TMA gas, as described in FIGS. 2A to 4D. Sublimabilities of the generated reaction products differ depending on whether the NH₃ gas or the TMA gas is used as the etching gas as described so far, affecting whether the central portion or the peripheral edge portion of the SiOx film 11 becomes higher after the etching. In Example, all of these gases are used. By doing so, a balance between the actions of these gases may be achieved, thereby preventing the lateral central portion from becoming higher than the ends as illustrated in the lower right section of FIG. 5 compared to the case of using the NH₃ gas alone, or preventing the left and right ends from becoming higher than the central portion as illustrated in the upper right section of FIG. 5 compared to the case of using the TMA gas alone. Further, as illustrated in the middle right section of FIG. 5, it is also possible to equalize the height between the lateral central portion and the left and right ends.

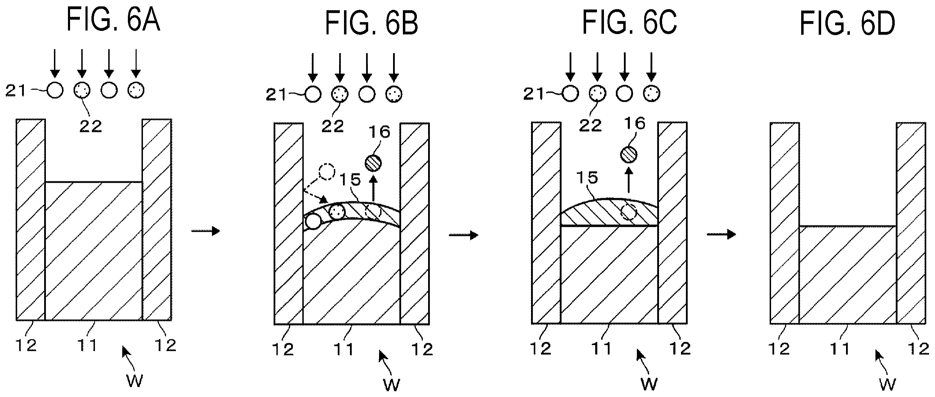

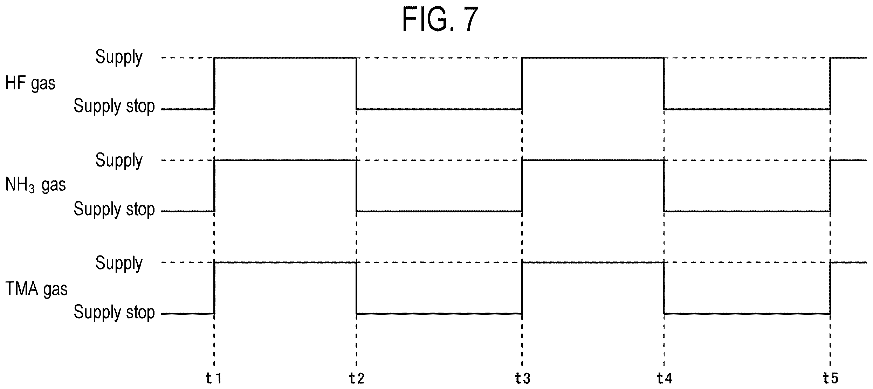

The etching step in Example is described with reference to vertical cross-sectional views of FIGS. 6A to 6D and a timing chart of FIG. 7. The timing chart illustrates timings at which gases are supplied respectively to the wafer W. As described later, the wafer W is stored and processed in a processing container, and FIG. 7 illustrates supply and stop timings of the respective gases into the processing container. Further, an interior of the processing container is exhausted to create a vacuum atmosphere at a predetermined pressure, and the wafer W adjusted to a predetermined temperature is etched.

A HF gas, NH₃ gas, and TMA gas are supplied as etching gases to the wafer W in the processing container (at time t1 in the chart). That is, the respective gases illustrated as the etching gases 21 and 22 in FIGS. 2A to 4D are supplied to the wafer W (FIG. 6A). Among these gases, the HF gas and NH₃ gas (etching gas 21) act on the SiOx film 11, forming the AFS layer 15 as described in Comparative Example 1. However, since a basic gas includes the TMA gas, a partial pressure of the NH₃ gas may be relatively reduced, thereby allowing the thickness of the AFS layer 15 to be relatively thin. With the AFS layer 15 being relatively thin in this way, the respective etching gases may pass through the AFS layer 15 and act on the SiOx film 11.

The AFS layer 15 is formed such that the thickness in the lateral central portion is greater than the thickness in the left and right ends, as described in Comparative Example 1. Accordingly, regarding a shielding effect of the AFS layer 15 against the etching gases on the SiOx film 11, the effect is greater in the central portion than in the left and right ends of the SiOx film 11, resulting in prevention of the etching in the central portion. However, as described in Comparative Example 2, the collision probability of the etching gas 22 in the lateral central portion of the SiOx film 11 is relatively high due to the presence of the Si film 12, leading to the generation of the reaction product 16, which then sublimates. In addition, the etching gas 21 also collides relatively more frequently with the lateral central portion, similarly to the etching gas 22.

In this way, a balance is achieved between the shielding effect of the AFS layer 15 and the difference in the collision probabilities of the respective gases, so that the SiOx film 11 undergoes highly uniform modification across both the lateral central portion and the ends (FIG. 6B). Then, the supply of each of the HF gas, NH₃ gas, and TMA gas to the wafer W is stopped (at time t2). Then, the wafer W is subjected to temperature adjustment and the processing container is exhausted, causing the AFS layer 15 to sublimate and be removed (FIG. 6C). In addition, if other reaction products such as the reaction product 16 remain on the SiO film 11, they also sublimate and are removed, exposing the surface of the SiO film 11.

After a predetermined period has passed from time t2, the etching gases, i.e., the HF gas, NH₃ gas, and TMA gas are again supplied to the wafer W (at time t3), and react with the SiOx film 11. After that, the supply of the etching gases to the wafer W is stopped (at time t4), and the reaction products on the SiOx film 11 are removed by sublimation of the reaction products and exhaust of the processing container, whereby the etching progresses and the SiOx film 11 is exposed. Subsequently, after a predetermined period has passed from time t4, the etching gases, i.e., the HF gas, NH₃ gas, and TMA gas are again supplied to the wafer W (at time t5).

If the processing from time t1 to just before time t3 is regarded as a first cycle, the processing from t3 to just before time t5 corresponds to a second cycle, which is performed in the same manner as the first cycle, thereby etching the SiOx film 11. The cycle is repeatedly performed after time t5, and etching progresses with each cycle. Once a desired amount of the SiOx film 11 has been etched through repeating of the cycle for a predetermined number of times, the processing of the wafer W is completed (FIG. 6D). In each cycle, the SiOx film 11 is etched with high uniformity between the lateral central portion and the left and right ends, resulting in a relatively high surface flatness of the SiOx film 11 upon completion of the processing.

In addition, in each cycle, a period during which at least one selected from the group of the etching gases is being supplied corresponds to an etching period, while a period during which none of the etching gases are being supplied corresponds to an exhaust period. Accordingly, in the etching as illustrated in FIG. 7, periods between times t1 and t2 and between times t3 and t4 correspond to the etching period, and periods between times t2 and t3 and between times t4 and t5 correspond to the exhaust period.

A supplementary description is provided regarding the shape of the SiOx film 11 after the etching with reference to FIG. 5. As described above, the AFS generated from the etching gases significantly affects the shape and flatness of the SiOx film 11 after the etching. When the processing is performed as described in FIGS. 6A to 6D and 7 under conditions where generation of the AFS is prevented or the sublimability is high, the effect of the collision probability of the TMA gas becomes more pronounced, making the SiOx film more likely to assume a concave shape, as illustrated in the upper right section of FIG. 5.

Specifically, when the processing container is maintained at a relatively low pressure, a flow rate of the TMA gas supplied into the processing container is relatively high compared to a flow rate of the NH₃ gas supplied into the processing container, the temperature of the wafer W is relatively high, and/or a period from stopping of the supply of the etching gases to a next etching gas supply (i.e., the periods between times t2 and t3 and between times t4 and time t5) is relatively long, the SiOx film 11 tends to have a concave shape. Conversely, when the processing container is maintained at a relatively high pressure, the flow rate of the TMA gas supplied into the processing container is relatively low compared to the flow rate of the NH₃ gas supplied into the processing container, the temperature of the wafer W is relatively low, and/or the exhaust period after the etching is relatively short, the SiOx film 11 after the etching tends to have a convex shape, as illustrated in the lower right section of FIG. 5.

In other words, the surface shape of the SiOx film 11 after the etching may be controlled to further increase the flatness thereof by adjusting various processing conditions, in addition to using both the amine gas and the NH₃ gas as the etching gases. In later evaluation tests, a desirable range of the flow rate of the TMA gas relative to the flow rate of the NH₃ gas, among the above-mentioned processing conditions, is described for improving the surface flatness of the SiOx film 11.

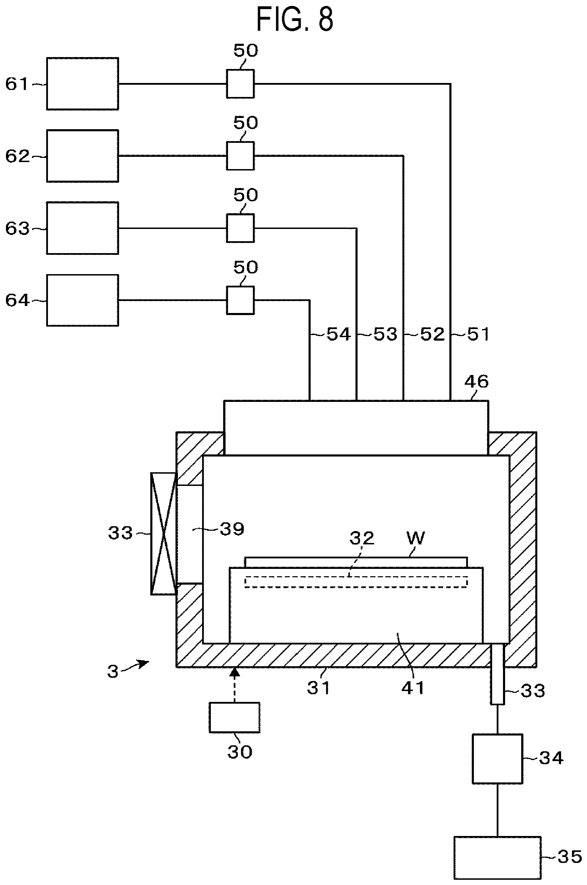

Next, an etching apparatus 3 that performs the etching according to the present disclosure is described with reference to a vertical cross-sectional view of FIG. 8. In the drawing, reference numeral 31 denotes a processing container included in the etching apparatus 3. In the drawing, reference numeral 39 denotes a transport port for the wafer W that is opened at a sidewall of the processing container 31, and is opened or closed by a gate valve 33. A stage 41 on which the wafer W is placed is provided inside the processing container 31, and a lifting pin (not illustrated) is provided at the stage 41. The wafer W is delivered between the stage 41 and a substrate transporter disposed outside the processing container 31 by the lifting pin.

A temperature adjuster 32 is embedded in the stage 41, and the wafer W placed on the stage 41 is temperature-adjusted. The temperature adjuster 32 is configured, for example, as a flow path that forms a part of a circulation path through which a temperature adjustment fluid such as water flows, and the temperature of the wafer W is adjusted through heat exchange with the fluid. However, the temperature adjuster 32 is not limited to such a fluid flow path, and may also be configured by, for example, a heater for performing resistance heating. The temperature of the wafer W (a surface temperature of the stage 41) when supplying the etching gases may be set to, for example, a range of -20 degrees C to 150 degrees C, in order to perform the sublimation of AFS.

Further, one end of an exhaust pipe 33 opens to the interior of the processing container 31, while the other end of the exhaust pipe 33 is connected to an exhauster 35, which is configured by, for example, a vacuum pump, via a valve 34, which is a pressure changer. By adjusting an opening degree of the valve 34, an internal pressure of the processing container 31 is set to a predetermined pressure, and the etching is performed on the wafer W. This pressure is, for example, from 0.133 Pa to 1.3 × 10⁴ Pa.

A gas shower plate 46 is provided at an upper portion of the processing container 31 so as to face the stage 41. The gas shower plate 46 is connected to downstream sides of gas supply paths 51 to 54, while upstream sides of the gas supply paths 51 to 54 are connected respectively to gas supply sources 61 to 64 via respective flow rate adjusters 50. Each flow rate adjuster 50 includes a valve and a mass flow controller. The supply and stop of each gas from the gas supply sources 61 to 64 to a downstream side are performed by opening and closing the valve included in the flow rate adjuster 50. Further, a flow rate of each gas supplied to the downstream side is adjusted by each flow rate adjuster 50. Each gas supplied to a gas flow path provided in the shower plate 46 is discharged downward from a number of discharge ports formed at a lower surface of the shower plate 46. A gas supplier includes the gas shower plate 46, the flow rate adjuster 50, and the gas supply sources 61 to 64.

A HF gas, TMA gas, N₂ gas, and NH₃ gas are respectively supplied from the gas supply sources 61, 62, 63 and 64, and each of these gases is supplied into the processing container 31 through the gas shower plate 46. The supply of each of these gases may be performed independently of each other by each flow rate adjuster 50. The N₂ gas, which is an inert gas, is supplied as a carrier gas into the processing container 31 through the gas shower plate 46 together with the etching gases. Further, during the execution of the above-described cycle, the N₂ gas is supplied into the processing container 31 as a purge gas even during a period in which the etching gases are not being supplied. That is, the N₂ gas is continuously supplied into the processing container 31 during the processing of the wafer W.

Further, the etching apparatus 3 includes a controller 30, which is a computer. The controller 30 includes a program, a memory, and a CPU. The program includes instructions (steps) for performing the above-described processing and transport of the wafer W. This program is stored in a storage medium such as a compact disk, a hard disk, a magneto-optical disk, and a DVD, and is installed to the controller 30. The controller 30 outputs control signals to various components of the etching apparatus 3 by using this program, and thus controls operations of the components. Specifically, examples of the operations of the etching apparatus 3 that are controlled in this manner include the adjustment of the temperature of the fluid supplied to the stage 41, the supply and stop of each gas from the gas shower plate 46, and the adjustment of an exhaust flow rate by the valve 34.

In addition, although the TMA gas is used as an amine gas in the above processing, an amine gas other than the TMA gas may also be used. Specifically, various gases of an amine compound such as dimethylamine, dimethylethylamine, diethylamine, triethylamine, monotertiarybutylamine, pyrrolidine, and pyridine may be used. Thus, any of primary, secondary, or tertiary amines may be used as the etching gas. Then, the etching gas may be appropriately selected depending on a film material of an etching workpiece. When etching the SiOx film 11, for example, halogen-containing gases other than HF, such as HCl, HBr, HI, and SF₆ may be used.

Although the processing illustrated in the chart of FIG. 7 involves multiple repetitions of the cycle, the cycle may be performed only once without repetition if a required etching amount is small. Also, in the example illustrated in the timing chart, the respective gases are supplied such that a supply period of the HF gas, a supply period of the TMA gas, and a supply period of the NH₃ gas overlap with one another, but the supply periods of these gases may not overlap. Accordingly, for example, the HF gas, TMA gas, NH₃ gas may be supplied to the wafer W one by one in sequence. Further, two of the three etching gases may be supplied first to the wafer W, followed by the remaining one. In other words, the supply periods of only two of the three gases may overlap with each other.

Even if the supply periods of the three etching gases are shifted in this manner, a single cycle may be configured such that, after supplying each etching gas to the wafer W, an exhaust period during which no etching gas is supplied may be provided to sublimate the reaction products on the wafer W. That is, the SiOx film 11 may be etched by repeating a cycle including an etching period during which at least one selected from the group of the three etching gases is supplied and the exhaust period following the etching period.

In addition, although the supply periods of the three etching gases may be shifted in this manner, it is desirable, from the viewpoint of increasing an etching rate by raising partial pressures of the etching gases around the wafer W, that the supply periods of the three etching gases overlap. It is more desirable that the three etching gases are supplied simultaneously as illustrated in FIG. 7 (i.e., starting time points of the supply periods are the same and supply stopping time points are also the same).

Incidentally, it has been described that etching gases include halogen, amine, and NH₃ as components. In the present disclosure, when an etching gas or a film as an etching workpiece is described as containing a specific component, it does not mean that the component is merely contained as an impurity, but rather that it is contained as a constituent component.

The configuration of the apparatus is arbitrary, and for example, for the gas supply paths 51 to 53, which serve as flow paths for the etching gases, tanks are interposed respectively as gas reservoirs for storing the gases, and valves are interposed respectively downstream of the tanks. By opening and closing these valves, supply of the gases from the tanks into the processing container 31 is switched on and off. Further, the apparatus may be configured to supply each etching gas into the processing container 31 at a relatively large flow rate over a relatively short period by storing the gas in the tank while the valve is closed and by opening the valve while an interior of the tank is pressurized. In addition, downstream portions of the gas supply paths 52 and 54 may be merged into a common path, and the aforementioned tank and valve may be provided in this common portion, so that the NH₃ gas and TMA gas are stored in the common tank and supplied into the processing container 31 through the common valve. Then, as for the HF gas, to prevent unnecessary reactions with the NH₃ gas and TMA gas, it is desirable that the HF gas be stored in a separate tank from the tank used for the NH₃ gas and TMA gas and be supplied into the processing container 31. That is, the HF gas may be stored in the tank of the gas supply path 51 and supplied into the processing container 31 through the valve of the gas supply path 51.

However, the recess 14 in which the SiOx film 11 is provided is not limited to being open upward (in the thickness direction of the substrate), and may also open laterally. Further, with regard to a positional relationship between the SiOx film 11 and the Si film 12, an etching amount of the SiOx film 11 in the region near the interface of the Si film 12 and an etching amount in the region relatively distant from the interface may be controlled by the present technique as long as the SiOx film 11 and the Si film 12 are adjacent to each other and both are exposed on the surface of the substrate W. In other words, the SiOx film 11 is not limited to being provided in the recess 14, the sidewall of which is formed by the Si film 12. In addition, the present technique is not limited to cases where both the SiOx film and another type of the silicon-containing film are simultaneously exposed on the surface of the substrate, and may also be applied to cases where the SiOx film 11 is provided over the entire surface of the substrate and is etched.

In addition, the sidewall of the recess 14 on which the SiOx film 11 is provided is formed by the Si film 12, and as described above, it is presumed that the low adsorbability of the Si film 12 to the reaction products contributes to the shape of the SiOx film 11 after etching. A silicon-containing film other than the Si film 12, such as a SiGe film, also has low adsorbability to the reaction products, and exhibits high resistance to the above-described etching gases (halogen-containing gas and basic gas), just like the Si film 12. Therefore, it is considered that the etching using the etching gases is effective even when the sidewall of the recess 14 is formed by a silicon-containing film other than the Si film 12 such as a SiGe film.

The embodiments disclosed herein should be considered as illustrative and not restrictive in all respects. The above embodiments may be omitted, replaced, modified and combined in various ways without departing from the scope of the appended claims.

Evaluation tests performed in relation to the present technique are described below.

### [Evaluation Test 1]

As Evaluation Test 1, energy amounts ( Δ G/eV) required for adsorption of each of HF, NH₃, TMA, and AFS to silicon nitride (SiN), silicon oxide (SiO), Si, and AFS are calculated through simulation. The results are shown in Table 1. Numerical values in the table represent the respective energy amounts, with smaller values indicating higher adsorbability.

**[Table 1]**

| | SiN | SiO | SI | AFS |
|---|---|---|---|---|
| HF | -0.21 | -0.02 | 0.24 | -0.4 |
| NH3 | 0.19 | 0.01 | 0.28 | -0.23 |
| TMA | 0.18 | -0.05 | 0.31 | -0.24 |
| AFS | -0.31 | -0.51 | 0.17 | -1.24 |

As illustrated in Table 1, adsorbability between AFS molecules is high, indicating a tendency for the molecules to aggregate. Then, AFS and NH₃ are easily adsorbed to SiO, but they are less likely to be adsorbed to Si. Therefore, when the NH₃ gas is included as the etching gas, it is presumed that the reaction progresses as described in FIGS. 2A to 2D and other drawings. That is, it is conceivable that selective etching of the SiOx film 11 with respect to the Si film 12 is performed, and that the AFS layer 15 has a relatively small thickness at the left and right ends of the SiOx film 11, as illustrated in FIG. 2D.

Further, TMA exhibits relatively high adsorbability to SiO but relatively low adsorbability to Si. Adsorbabilities of NH₃ to SiO and Si are similar to those of TMA to SiO and Si. Therefore, as described in FIGS. 6A to 6D, it is observed that when both the TMA gas and the NH₃ gas are used as the etching gases, the SiOx film 11 may be selectively etched with respect to the Si film 12.

Further, as illustrated in Table 1, SiN has higher adsorbability to AFS than Si. Accordingly, as described in FIGS. 2A to 2D, when the NH₃ gas is used for the etching and the sidewall of the recess 14 is formed by a SiN film, it is estimated that AFS is less likely to peel off, and the etching amount at the left and right ends is reduced. Therefore, it is considered that the sidewall of the recess 14 may be formed by a SiN film, but the present technique is more effective when the sidewall is formed by a Si film.

### [Evaluation Test 2]

As Evaluation Test 2, etching was performed on the SiOx film 11 in the recess 14 of the substrate having films formed thereon, as illustrated in FIG. 1, using a test apparatus similar to the etching apparatus 3, by supplying a HF gas, NH₃ gas, and TMA gas as described in Example. The HF gas, NH₃ gas, and TMA gas were supplied into the processing container 31, as illustrated in the chart of FIG. 7. Thus, the respective gases were simultaneously supplied to the substrate.

In Evaluation Test 2, a flow rate ratio between the TMA gas and the NH₃ gas supplied into the processing container 31 was changed for each substrate during processing. Then, SEM images of each substrate after etching were acquired and the state of the recess 14 was observed. Specifically, a height difference between a top of the Si film 12 and the lateral central portion of the SiOx film 11 (referred to as a "central etching depth") and a height difference between the top of the Si film 12 and the left and right ends of the SiOx film 11 (referred to as an "end etching depth") were respectively acquired. Then, an etching depth difference was calculated as the end etching depth - central etching depth. Accordingly, the smaller an absolute value of the etching depth difference, the higher the uniformity in the surface height of the SiOx film 11, i.e., the higher the uniformity of etching across the SiOx film surface. In the following description, a value obtained by dividing the flow rate of the TMA gas supplied to the processing container 31 by the flow rate of the NH₃ gas supplied to the processing container 31 (i.e., a ratio of the flow rate of the amine gas to the flow rate of the ammonia gas) may be referred to as the "TMA gas flow rate / NH₃ gas flow rate."

The TMA gas flow rate / NH₃ gas flow rate was set to 11:1 in Evaluation Test 2-1, 9:3 in Evaluation Test 2-2, 7:5 in Evaluation Test 2-3, 1:1 in Evaluation Test 2-4, 5:7 in Evaluation Test 2-5, 3:9 in Evaluation Test 2-6, and 1:11 in Evaluation Test 2-7. Accordingly, the flow rate ratio is 11(=11/1) in Evaluation Test 2-1, 3(=9/3) in Evaluation Test 2-2, 1.4(=7/5) in Evaluation Test 2-3, 1(=1/1) in Evaluation Test 2-4, 0.71(=5/7) in Evaluation Test 2-5, 0.33(=3/9) in Evaluation Test 2-6, and 0.09(=1/11) in Evaluation Test 2-7.

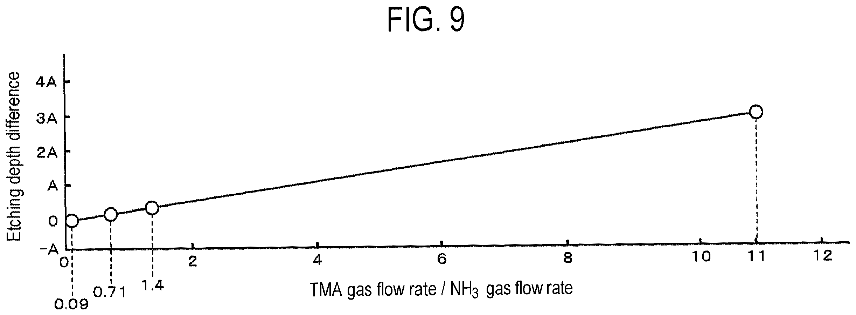

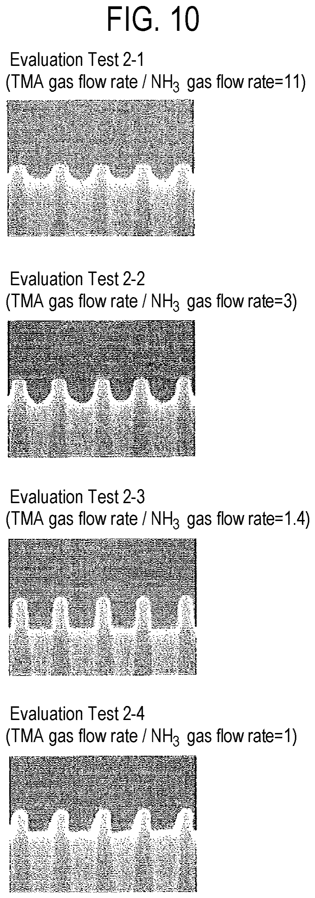

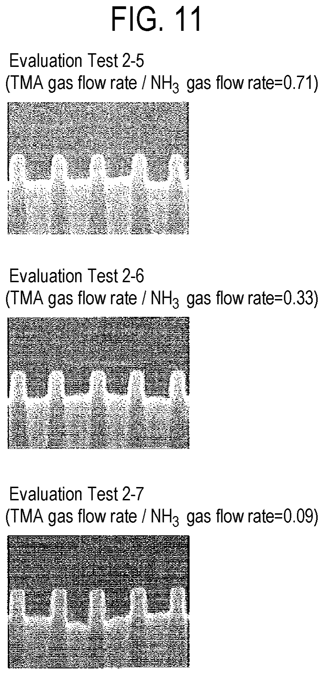

A graph in FIG. 9 and images in FIGS. 10 and 11 show results of Evaluation Test 2. The graph shows the results of Evaluation Tests 2-1, 2-3, 2-5, and 2-7 as representative examples. The horizontal axis of the graph represents the TMA gas flow rate / NH₃ gas flow rate, and the vertical axis represents the etching depth difference, with scales provided at intervals of a predetermined numerical value (represented as "A" in the drawing). From the graph, it is seen that the absolute value of the etching depth difference in Evaluation Test 2-1 is relatively large, while in Evaluation Tests 2-3, 2-5, and 2-7, the absolute value of the etching depth difference is relatively small, indicating high height uniformity of the SiOx film 11.

Further, based on the respective images, for the SiOx film 11, the smaller the TMA gas flow rate / NH₃ gas flow rate, the more the surface of the SiOx film 11 tends to have a convex shape, with the left and right ends lower than the lateral central portion. Then, it is seen that the larger the TMA gas flow rate / NH₃ gas flow rate, the more the surface of the SiOx film 11 tends to have a concave shape, with the left and right ends higher than the lateral central portion. In Evaluation Tests 2-1 and 2-2, the SiOx film 11 exhibits a pronounced concave shape, and the difference between the lateral central portion and the left and right ends is relatively large, but in Evaluation Tests 2-3 to 2-7, the difference between the lateral central portion and the left and right ends is suppressed, indicating relatively high surface flatness of the SiOx film 11. It is particularly seen from the images that the flatness is high in Evaluation Tests 2-3 to 2-6. Accordingly, it is seen from Evaluation Test 2 that when the TMA gas and NH₃ gas are supplied to the substrate such that the supply periods thereof overlap, it is desirable to set the TMA gas flow rate / NH₃ gas flow rate to a value less than 3, and more desirable in a range of 0.33 to 1.4.

### [Evaluation Test 3]

In Evaluation Test 3, etching of the SiOx film (11) was performed on multiple substrates by supplying the respective etching gases as illustrated in the chart of FIG. 7, in the same manner as in Evaluation Test 2. In Evaluation Test 3, while keeping the TMA gas flow rate / NH₃ gas flow rate for each substrate constant, the temperatures of the respective substrates were individually set to different values during etching. Specifically, in Evaluation Tests 3-1, 3-2, and 3-3, the temperatures of the substrates were set to 80 degrees C, 90 degrees C, and 100 degrees C, respectively.

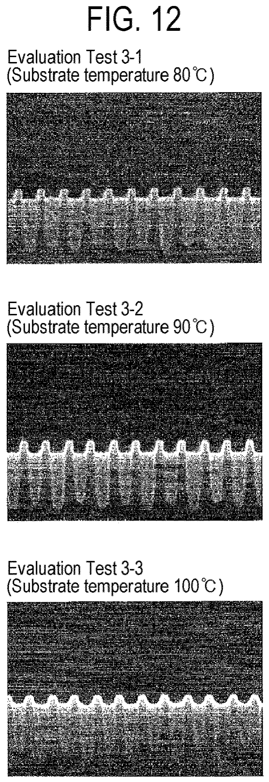

Images in FIG. 12 show results of Evaluation Test 3. In Evaluation Test 3-3, a tendency of forming a concave shape appeared most prominently, while in Evaluation Test 3-1, this tendency was the least apparent.

This is believed to be due to the sublimability of AFS, as described in the embodiment. Further, in Evaluation Tests 3-1 and 3-2, the surface flatness of the SiOx film 11 was relatively high. Accordingly, it was confirmed in Evaluation Test 3 that the temperature of the substrate during the etching may be less than 100 degrees C, and more particularly be equal to or less than 90 degrees C. Accordingly, it was confirmed in Evaluation Test 3 that it is desirable to make the temperature of the substrate during the etching to be less than 100 degrees C, and more particularly, to be equal to or less than 90 degrees C.

### EXPLANATION OF REFERENCE NUMERALS

W: wafer, 11: silicon oxide (SiOx) film, 21: etching gas (HF gas, NH₃ gas), 22: etching gas (HF gas, TMA gas)

## Claims

1. An etching method comprising etching a silicon oxide film by supplying a halogen-containing gas, an ammonia gas, and an amine gas as etching gases to a substrate including the silicon oxide film formed on a surface of the substrate.

2. The etching method of Claim 1, wherein the silicon oxide film and a silicon-containing film different in type from the silicon oxide film are adjacent to each other and are both exposed on the surface of the substrate, and
wherein the etching includes selectively etching the silicon oxide film, among the silicon oxide film and the silicon-containing film.

3. The etching method of Claim 2, wherein the silicon-containing film different in type from the silicon oxide film is a silicon film.

4. The etching method of Claim 3, wherein the surface of the substrate is provided with a recess including a sidewall formed by the silicon film, and
wherein the etching includes etching the silicon oxide film formed in the recess.

5. The etching method of Claim 1, wherein a cycle, which includes an etching period during which at least one of the etching gases is supplied to the substrate and an exhaust period during which supply of the respective etching gases to the substrate is stopped after the etching period and an atmosphere around the substrate is exhausted, is repeated.

6. The etching method of Claim 5, wherein periods during which the halogen-containing gas, the ammonia gas, and the amine gas are supplied respectively to the substrate overlap with one another.

7. The etching method of Claim 5, wherein periods during which the ammonia gas and the amine gas are supplied respectively to the substrate overlap with each other, and
wherein a ratio of a flow rate of the amine gas to a flow rate of the ammonia gas supplied to the substrate is less than 3.

8. An etching apparatus comprising:
a processing container configured to store a substrate including a silicon oxide film formed on a surface of the substrate; and
a gas supplier configured to supply a halogen-containing gas, an ammonia gas, and an amine gas as etching gases to etch the silicon oxide film.
